Europäisches Patentamt

European Patent Office

Office européen des brevets

(19)

(11) Publication number: **0 140 579**
**B1**

# (12) EUROPEAN PATENT SPECIFICATION

(45) Date of publication of patent specification: **25.05.88**

(51) Int. Cl.⁴: **H 03 B 23/00,** G 01 S 13/28

(21) Application number: **84306535.0**

(22) Date of filing: **26.09.84**

(54) **Signal processing apparatus.**

(30) Priority: **27.09.83 GB 8325783**

(43) Date of publication of application:
**08.05.85 Bulletin 85/19**

(45) Publication of the grant of the patent:
**25.05.88 Bulletin 88/21**

(84) Designated Contracting States:
**DE FR IT SE**

(56) References cited:
**DE-A-2 614 859**
**FR-A-2 528 991**
**GB-A-1 554 883**
**US-A-4 123 719**
**US-A-4 166 212**
**US-A-4 216 474**

(73) Proprietor: **The General Electric Company, p.l.c.**
**1 Stanhope Gate**
**London W1A 1EH (GB)**

(72) Inventor: **Parsons, Nicholas John**
**4 Upper Bridge Road**
**Chelmsford Essex (GB)**

(74) Representative: **Hoste, Colin Francis**
**The General Electric Company p.l.c. Central**
**Patent Department (Chelmsford Office) Marconi**
**Research Centre West Hanningfield Road**
**Great Baddow Chelmsford CM2 8HN, Essex (GB)**

Courier Press, Leamington Spa, England.

## Description

This invention relates to signal processing apparatus, and more particularly to apparatus for improving the linearity of chirp pulses.

A chirp pulse is a pulse having a frequency which varies with time and is often used in radar pulse compression techniques. In this application it is desirable for the change in frequency to be as linear as possible to obtain the optimum signal to noise ratio.

A typical method of improving the linearity of chirp pulses, as described in US-A-4123719, involves transmitting a chirp signal along a coaxial delay line. Delayed and undelayed versions of the signal are mixed to give a difference frequency which remains constant when the chirp pulse is linear. Any departure from linearity results in a change in the difference frequency which may be used in a control circuit to adjust the oscillator which generates the chirp signal. However such a method has certain disadvantages such as loss, dispersion and bandwidth limitations introduced by the co-axial delay line. Also the rf chirp signal must be mixed down to within this bandwidth, involving additional circuitry.

Arrangements are known in which optical signals are delayed by transmitting them along optical delay lines. as described in US-A-4166212.

In another arrangement, described in GB-A-1554883, a signal is modified by being passed along acoustic wave dispersive delay lines.

This invention seeks to provide an improved signal processing apparatus which is capable of generating linear chip pulses and can, if desired, operate direcly at the chirp frequency.

According to the invention there is provided signal processing apparatus comprising a source producing a source signal and means for amplitude modulating the source signal with the same modulating signal at first and second locations along the path of the source signal and remote from the source, such that the source signal at the second location is modulated by a delayed version and an undelayed version of the modulating signal, characterised in that the source signal is optical radiation and in that a substantially non-dispersive optical delay line is included between the first and second locations providing the delayed version of the modulating signal.

In employing the invention, the optical radiation does not need to be coherent and may be infra-red or visible light. The signal resulting from amplitude modulating the optical radiation twice includes upper and lower sidebands. The lower sideband can be detected directly by a low bandwidth detector, such as a silicon photodiode and the higher frequency signals discarded. Thus the limited bandwidth of optical signals to which the photodiode is sensitive does not cause any reduction in efficiency. Also no further processing is required to obtain a useful signal. The modulating signal is usually a chirp signal although other types of signal may be used.

It is also preferred that the means for amplitude modulating the radiation includes an electro-optic modulator, and preferably this comprises a Mach-Zehnder modulator. This then permits an integrated optics format with the attendant advantages of compactness, robustness, and wideband frequency operation, the modulator and light guides being laid down on a substrate such as lithium niobate.

Preferably the means for amplitude modulating the radiation includes two amplitude modulators connected optically in series and electrically in parallel, although if the modulators are of the travelling-wave type they may be connected electrically in series.

According to a feature of the invention a chirp lineariser includes apparatus as described above and wherein the modulating signal is representative of the chirp signal. The lower sideband of the signal after amplitude modulation may be detected by a photodiode to give an indication of the frequency difference between delayed and undelayed parts of a chirp pulse. If this difference remains constant, the frequency change of the chirp pulse is linear, but if there is a variation in the difference, the frequency change deviates from linearity. The changing difference may then be used to provide feedback to improve linearity of the chirp pulse.

The invention is now further described by way of example with reference to the accompanying drawing, in which:-

Figure 1 is a schematic representation of apparatus in accordance with the invention;

Figure 2 illustrates part of the apparatus of Figure 1, and;

Figure 3 is an explanatory diagram relating to Figure 1.

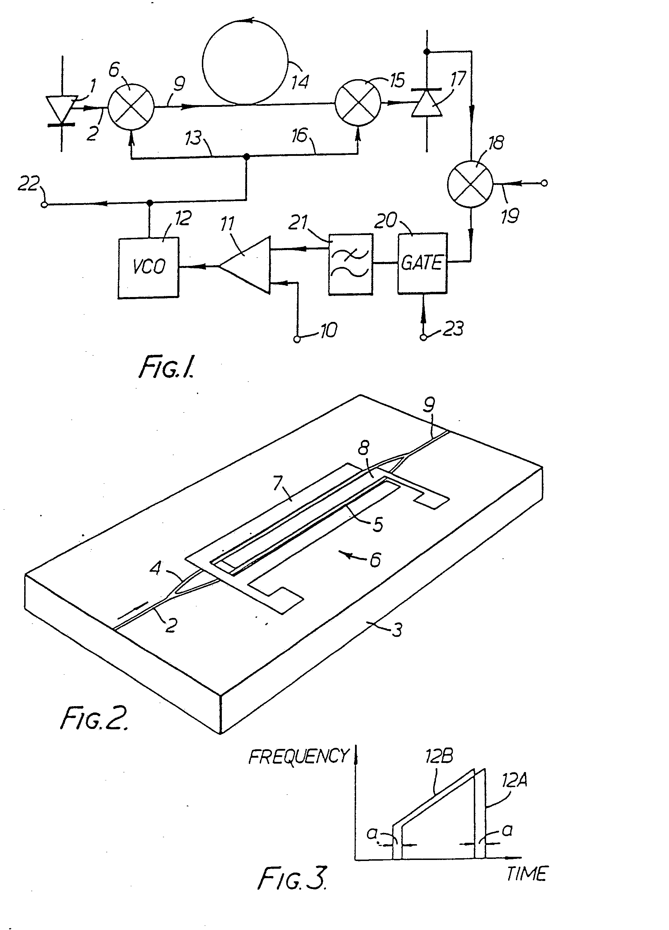

With reference to Figure 1, a chirp lineariser includes a light source 1 which generates a beam of light. The light is transmitted along a light guide 2 which is formed on a Y-cut lithium niobate substrate 3, (as shown in Figure 2) by diffusing titanium into the substrate 3 along the appropriate path.

Referring to Figure 2, light on the light guide 2 enters a first amplitude modulator 6 at a first location along the path travelled by the light. The light guide 2 branches into two arms 4 and 5 in the modulator 6 and the light is divided equally between them, travelling between a pair of interdigitated electrodes 7 and 8 before being recombined on an output light guide 9. The modulator 6 is an integrated version of a Mach-Zehnder interferometer. In operation a potential difference is applied across the electrodes and introduces a phase difference between the light carried on one arm and that carried on the other because of the electro-optic properties of the lithium niobate substrate 3. By controlling the potential difference the phase difference can be adjusted and, depending on this phase difference, the light either propagates along the output light guide 9 on recombination or radiates into the substrate. Thus the light carried by the guide 9 may be amplitude modulated.

The signal which drives the electrodes of the first amplitude modulator 6 is derived from an input 10 which is a 'ramp' waveform. This has a voltage which increases linearly with time until a certain peak amplitude is reached, when it drops down to its starting amplitude. The signal may be a single μs pulse or a series of pulses and is passed via a differential amplifier 11 having unity gain to a voltage controlled oscillator 12. The frequency of the output of the oscillator 12 is dependent on the voltage of the signal applied to it. The output of the oscillator 12 is thus a chirp pulse (which is illustrated at 12A on Figure 3) and is applied via a line 13 to the electrodes 7 and 8 to amplitude modulate the light in a manner as described above.

The modulated light signal on line 9 is passed via a fibre optic delay line 14 of about 200m length, and imposing a lμs delay, to a second amplitude modulator 15 which is identical to the first and is positioned at a second location along the light path. The electrodes of the second amplitude modulator 15 are driven by the same signal which drives the first modulator 6, applied on a line 16.

Both modulators 6 and 15 are controlled by the oscillator 12 but because they are spaced apart along the path travelled by the light, the modulations imposed on the light at the second location are different from those it already carries and which were imposed by the first modulator 6. In effect, the light at the second location is amplitude modulated by a delayed and undelayed version of the modulating signal, the undelayed version being that controlling the second modulator 15. This results in the light from the second modulator 15 carrying a signal having upper and lower sidebands, the frequency of the lower sideband being representative of the difference in frequency between the delayed and undelayed versions. The light is then transmitted to a photodetector 17 which is sensitive to low frequency signals over a narrow bandwidth and does not detect the upper sideband. The output signal from the photodetector 17 is thus representative of the lower sideband, and hence the frequency difference between different parts of the chirp pulse used to drive the electrodes of the modulators 6 and 15. If the ramp waveform is perfectly linear, the difference remains constant, since the frequency difference between the delayed and undelayed parts of the pulse remains constant. Any deviation from linearity of the chirp pulse causes the frequency difference to vary.

The difference signal from the photodetector 17 is applied to a phase sensitive detector 18, where it is compared with a constant reference signal on line 19. The output of the phase sensitive detector 18 is zero if the difference remains constant. Any change in the signal causes an error signal to be generated and passed, via a gate 20, to a low pass filter 21 of about 500kHz bandwidth, which acts to cut out any transients and reduce noise. The output of the filter 21 is then applied to the amplifier 11 to reduce or increase the voltage applied to the oscillator 12 and produce a more linear waveform. The delay imposed by the optical delay line 14 is sufficiently short compared with the length of the chirp pulse so that the error signal received by the amplifier 11 is related to a previous part of the same pulse, the chirp pulse and the delay typically having durations of 100μs and lμs respectively. The resulting chirp pulse is taken from the circuit at 22 and passed on to further circuitry, for example to be transmitted by a radar system.

The gate 20 is required to ensure that the error signal which is produced when the undelayed and delayed waveforms do not coincide and where the light is amplitude modulated only once, i.e. for the time periods shown as a (about lμs) on Figure 3 where 12A and 12B represent the undelayed and delayed versions respectively, is not passed on to the voltage controlled oscillator 12. This is because such an error signal is not representative of the difference between the two waveforms and hence it is not indicative of the linearity of the pulses. The gate could be operated by enabling signals on line 23, to prevent signal passing through for a period of a after the leading and trailing edges of the pulse.

**Claims**

1. Signal processing apparatus comprising a source (1) producing a source signal, means (6, 12, 15) for amplitude modulating the source signal with the same modulating signal at first and second locations along the path of the source signal and remote from the source (1), such that the source signal at the second location (15), is modulated by a delayed version and an undelayed version of the modulating signal, characterised in that the source signal is optical radiation and in that a substantially non-dispersive optical delay line (14) is included between the first (6) and second (15) locations providing the delayed version of the modulating signal.

2. Apparatus as claimed in claim 1 and wherein the means for amplitude modulating the source signal includes an electro-optic modulator (6, 15).

3. Apparatus as claimed in claim 2 and wherein the electro-optic modulator (6, 15) is a Mach-Zehnder modulator.

4. Apparatus as claimed in any preceding claim and wherein the means for amplitude modulating the source signal includes two amplitude modulators (6, 15) connected optically in series and electrically in parallel.

5. Apparatus as claimed in any preceding claim and including an optical detector (17) arranged to detect the lower sideband of the radiation after it has been modulated at the first (6) and second (15) locations.

6. A chirp lineariser including apparatus as claimed in any preceding claim and wherein the modulating signal is representative of the chirp signal.

**Patentansprüche**

1. Signalverarbeitungsvorrichtung mit einer ein Quellsignal erzeugenden Quelle (1), Mitteln (6, 12, 15) zur Amplitudenmodulation des Quellsignales mit dem gleichen Modulationssignal an ersten und zweiten Stellen längs des Weges des Quellsignales und entfernt von der Quelle (1), so daß das Quellsignal an der zweiten Stelle (15) durch eine verzögerte Version und eine unverzögerte Version des Modulationssignales moduliert ist, dadurch gekennzeichnet, daß das Quellsignal optische Strahlung ist und daß eine im wesentlichen nichtdispersive optische Verzögerungsleitung (14), die die verzögerte Version des Modulationssignales schafft, zwischen der ersten (6) und der zweiten (15) Stelle enthalten ist.

2. Vorrichtung nach Anspruch 1 und in der die Mittel zur Amplitudenmodulation des Quellsignales einen elektro-optischen Modulator (6, 15) enthalten.

3. Vorrichtung nach Anspruch 2 und bei der der elektro-optische Modulator (6, 15) ein Mach/Zehnder-Modulator ist.

4. Vorrichtung nach einem der vorangehenden Ansprüche und bei der die Mittel zur Amplitudenmodulation des Quellsignales zwei Amplitudenmodulatoren (6, 15) enthalten, welche optisch in Reihe und elektrisch parallel geschaltet sind.

5. Vorrichtung nach einem der vorangehenden Ansprüche mit einem optischen Detektor (17), der zur Erfassung des unteren Seitenbandes der Strahlung ausgelegt ist, nachdem sie an der ersten (6) und der zweiten (15) Stelle moduliert wurde.

6. Zirp-Linearisator mit einer Vorrichtung nach einem der vorangehenden Ansprüche und bei dem das modulierende Signal für das Zirp-Signal repräsentativ ist.

**Revendications**

1. Appareil de traitement de signaux qui comprend une source (1) produisant un signal de source, un moyen (6, 12, 15) servant à moduler en amplitude le signal de source à l'aide du même signal de modulation en un premier et un deuxième emplacement se trouvant le long du trajet du signal de source et à distance de la source (1), de façon que le signal de source se trouvant au deuxième emplacement (15) soit modulé par une version retardée et une version non retardée du signal de modulation, caractérisé en ce que le signal de source est un rayonnement optique et en ce qu'une ligne à retard optique sensiblement non dispersive (14) est incluse entre le premier emplacement (6) et le deuxième emplacement (15) afin de fournir la version retardée du signal de modulation.

2. Appareil selon la revendication 1, où le moyen servant à moduler en amplitude le signal de source comporte un modulateur électro-optique (6, 15).

3. Appareil selon la revendication 2, où le modulateur électro-optique (6, 15) est un modulateur du type Mach-Zehnder.

4. Appareil selon l'une quelconque des revendications précédentes, où le moyen servant à moduler en amplitude le signal de source comporte deux modulateurs d'amplitude (6, 15) connectés optiquement en série et électriquement en parallèle.

5. Appareil selon l'une quelconque des revendications précédentes, comportant un détecteur optique (17) destiné à détecter la bande latérale inférieure du rayonnement après qu'il a été modulé au premier emplacement (6) et au deuxième emplacement (15).

6. Dispositif de linéarisation de signal chirp comportant un appareil tel que revendiqué dans l'une quelconque des revendications précédentes, où le signal de modulation est représentatif du signal chirp.

Fig.1.

Fig.2.

Fig.3.